# FASCICULE DE BREVET EUROPEEN

(11) **EP 3 699 618 B1**
(45) Date de publication et mention de la délivrance du brevet: **14.05.2025**
(21) Numéro de dépôt: 20156557.9
(22) Date de dépôt: 11.02.2020
(51) Int. Cl.: G01R 31/50

(54) **PROCÉDÉ ET DISPOSITIF DE DÉTECTION SUR CARTE DE DÉFAUTS ÉVENTUELS DANS UN SYSTÈME FIXÉ SUR LADITE CARTE**
ERKENNUNGSVERFAHREN UND -VORRICHTUNG VON EVENTUELLEN FEHLERN AUF EINER KARTE IN EINEM AUF DIESER KARTE FIXIERTEN SYSTEM
METHOD AND DEVICE FOR DETECTING ON A CARD ANY FAULTS IN A SYSTEM ATTACHED TO SAID CARD

(30) Priorité: 22.02.2019 FR 1901809
(43) Date de publication de la demande: 26.08.2020
(73) Titulaire: STMicroelectronics (Rousset) SAS, 13790 Rousset (FR)
(72) Inventeur: CORDIER, Nicolas, 13080 AIX EN PROVENCE (FR)
(74) Mandataire: Casalonga

(56) Documents cités:
- EP-A1- 2 570 818
- EP-A1- 2 806 586
- DE-A1- 102013 110 017
- KR-A- 20160 088 152
- US-A1- 2015 045 635
- ROHRL FRANZ XAVER ET AL: "Differential wideband interconnects for organic millimeter wave chip packages: An effort to design an all-purpose RF chip package", 2016 11TH EUROPEAN MICROWAVE INTEGRATED CIRCUITS CONFERENCE (EUMIC), EUROPEAN MICROWAVE ASSOCIATION, 3 October 2016 (2016-10-03), pages 536 - 539, XP033018107, DOI: 10.1109/EUMIC.2016.7777610

## Description

Des modes de mise en œuvre et de réalisation de l'invention concernent la détection de défauts éventuels dans le montage d'un système sur carte (« board » en langue anglaise), ladite carte étant par exemple une carte imprimée comportant des pistes et destinée à recevoir des composants, par exemple soudés sur celle-ci.

L'invention s'applique notamment mais non exclusivement, à un système comportant un composant sans contact couplé à un circuit d'adaptation d'impédance.

La communication sans contact utilise des composants électroniques connectés à une antenne et configurés pour échanger des informations avec un dispositif externe via ladite antenne selon un protocole de communication du type sans contact.

Un composant sans contact est un composant capable d'échanger des informations à travers une antenne avec un autre dispositif sans contact selon un protocole de communication du type sans contact.

De tels composants sans contact peuvent être par exemple des composants dits « NFC », c'est-à-dire des composants compatibles avec la technologie de communication en champ proche, dite technologie NFC (« Near Field Communication »).

Le composant NFC peut être par exemple un microcontrôleur NFC.

L'acronyme NFC (« Near Field Communication ») désigne une technologie de communication sans fil haute fréquence faible distance, qui permet des échanges de données entre deux dispositifs sans contact sur une faible distance, par exemple 10 cm.

La technologie NFC est normalisée dans les documents ISO/IEC 18 092 et ISO/IEC 21 481 mais incorpore une variété de normes préexistantes incluant les protocoles type A et type B de la norme ISO/IEC 14 443.

Un microcontrôleur NFC peut être généralement utilisé soit en mode « lecteur » ou en mode « carte », pour dialoguer avec un autre dispositif sans contact, par exemple en utilisant un protocole de communication sans contact tel que le protocole type A de la norme ISO/IEC 14 443.

Dans le mode « lecteur », le composant NFC agit comme un lecteur vis-à-vis du dispositif externe sans contact qui peut être alors une carte ou bien une étiquette. Dans le mode lecteur, le composant NFC peut alors lire le contenu du dispositif externe et écrire des informations dans le dispositif externe.

Dans le mode « carte », le composant NFC se comporte alors comme une carte ou une étiquette et dialogue avec le dispositif externe qui est cette fois-ci un lecteur.

Un microcontrôleur NFC peut être par exemple incorporé dans un téléphone mobile cellulaire, et ce dernier peut être utilisé alors, outre sa fonction téléphonique classique, pour échanger des informations avec le dispositif externe sans contact.

De nombreuses applications sont ainsi possibles, telles que le franchissement de barrière de péage dans les transports (le téléphone mobile agit comme ticket de transport) ou bien des applications de paiement (le téléphone mobile agit comme carte de crédit).

Les composants sans contact, tels que les composants NFC, sont généralement connectés à l'antenne par l'intermédiaire d'un circuit d'adaptation d'impédance dans le but d'optimiser la communication radiofréquence. Et, ces composants externes utilisés dans ce circuit d'adaptation d'impédance par exemple des bobines et des condensateurs, sont dimensionnés, de façon à permettre un bon accord fréquentiel de l'antenne, par exemple sur une fréquence de porteuse, (par exemple 13,56 MHz), et assurer ainsi le maximum de performance.

Généralement le circuit d'adaptation d'impédance incorpore un filtre destiné à filtrer les interférences électromagnétiques et communément désigné par l'homme du métier sous l'acronyme anglosaxon de filtre « EMI » (ElectroMagnetic Interference). Plus précisément ce filtre EMI, qui est généralement un filtre inductif capacitif (filtre LC), permet de réduire autant que possible les émissions d'harmoniques élevées du signal de transmission, typiquement à 13,56 MHz.

Le montage sur carte électronique d'un composant sans contact, en particulier un microcontrôleur NFC, et du circuit d'adaptation d'impédance, est complexe. Il nécessite généralement six broches, plus des broches dédiées à la masse, plus une douzaine de composants discrets, inductifs, résistifs, capacitifs, et deux connexions d'antenne.

La plupart des défauts détectés durant les tests de production des dispositifs sont dus au process d'assemblage sur la carte de circuit imprimé.

Il est préférable de détecter ces défauts suffisamment tôt dans la chaîne de production, par exemple au niveau du test de la carte électronique.

Les solutions classiques prévoient de tester chaque nœud du circuit d'adaptation d'impédance, ce qui nécessite des points de test et un analyseur de réseau par exemple, et ce en plaçant le circuit intégré dans différents modes.

On peut également faire délivrer au circuit intégré les signaux d'émission radiofréquence et mesurer la consommation de courant avec un ampèremètre externe et tester tous les nœuds du circuit d'adaptation d'impédance grâce aux points de test avec un oscilloscope externe.

Par ailleurs, les chaînes de test JTAG (Joint Test Action Group), bien connues de l'homme du métier, ne permettent pas de tester les connexions des interfaces radiofréquence.

Par ailleurs, les points de test prennent de la place sur la carte de circuit imprimé et ne sont pas accessibles lorsque le circuit intégré est recouvert d'un bouclier (« shield ») de telle sorte qu'il est nécessaire de prévoir des pistes additionnelles.

En outre, les équipements de mesure conduisent à un surcoût tant en termes de prix qu'en termes de temps de tests.

Les documents EP 2 806 586 A1, KR 2016 0088152 A et EP 2 570 818 A1 décrivent différentes approches pour la détection de défauts dans des systèmes comprenant un composant sans contact.

Il existe par conséquent un besoin de proposer une détection de défauts éventuels sur carte d'un système fixé sur la carte, comportant par exemple un composant sans contact, tel qu'un microcontrôleur NFC, connecté à un circuit d'adaptation d'impédance, qui remédie aux inconvénients mentionnés ci-avant et qui offre en particulier une détection simple et facile à mettre en œuvre et qui puisse être réalisée suffisamment tôt dans la production, par exemple au niveau du test de la carte imprimée, mais aussi éventuellement à un stade ultérieur voire directement dans un appareil incorporant le système, par exemple un téléphone mobile cellulaire, en particulier lors d'un retour client suite à un défaut constaté.

Selon un mode de mise en œuvre et de réalisation, il est proposé un autotest embarqué qui utilise le composant sans contact lui-même, et qui permet de faire le diagnostic de défauts éventuels dans l'assemblage du système fixé sur la carte.

Selon un aspect, il est proposé un procédé de détection sur carte de défauts éventuels dans un système fixé sur ladite carte, le système comportant un circuit d'adaptation d'impédance couplé à un composant sans contact, par exemple un microcontrôleur NFC, ladite détection comportant une première partie effectuée par le composant sans contact lui-même.

En d'autres termes, on utilise le composant sans contact lui-même pour effectuer au moins une première partie de ladite détection, typiquement des mesures de niveaux de grandeurs physiques tels que des courants et des tensions, ce qui permet de s'affranchir de l'utilisation de points de test et d'un appareillage de mesure externe.

Selon un mode de mise en œuvre, les défauts éventuels appartiennent au groupe comportant des défauts éventuels dans les composants du circuit d'adaptation d'impédance, des défauts éventuels au niveau des connexions de ces composants sur ladite carte, et des défauts éventuels au niveau des connexions du composant sans contact sur ladite carte.

Lors de la première partie, il est souhaitable de coupler le circuit d'adaptation d'impédance à une antenne. Ceci permet de prendre en compte également des défauts éventuels au niveau des points de couplage avec ladite antenne.

A titre d'exemple, un défaut éventuel peut comporter un défaut du type court-circuit ou un défaut du type circuit ouvert.

En d'autres termes, on peut ainsi détecter par exemple un composant du circuit d'impédance court-circuité ou bien un composant défectueux qui se traduit par un circuit ouvert.

De même, au niveau d'une broche ou d'un point de soudure on peut détecter un défaut dans cette soudure qui se traduit par un circuit ouvert ou bien par un court-circuit avec un autre élément conducteur.

L'antenne qui est couplée avantageusement au circuit d'adaptation d'impédance pendant la première partie peut être un dispositif émulant l'antenne, par exemple un circuit inductif résistif ou bien l'antenne réelle qui sera implémentée dans un appareil destiné à contenir ladite carte. Ceci peut être utile en particulier lorsque le procédé est mis en œuvre dans l'appareil lui-même, par exemple le téléphone, lors d'un retour client dû à un dysfonctionnement.

Selon un mode de mise en œuvre, ladite détection comporte une deuxième partie analysant des résultats issus de la première partie de façon à diagnostiquer les éventuels défauts.

Cette deuxième partie peut être effectuée également au sein du composant sans contact.

En variante, elle pourrait être effectuée au sein d'une unité de traitement, par exemple un microprocesseur, fixée sur la carte mais distincte du composant sans contact. Il serait également possible que cette deuxième partie soit effectuée au sein d'une unité de traitement non supportée par ladite carte, par exemple au sein d'une unité de traitement d'un banc de test.

Selon un mode de mise en œuvre, la première partie comporte des délivrances par le composant sans contact, de signaux de tests dans le circuit d'adaptation d'impédance et les résultats comportent alors des niveaux de grandeurs physiques résultant de ces délivrances de signaux de tests, les niveaux étant déterminés par le composant sans contact.

Là encore, on évite l'utilisation de moyens de mesure externes.

Et, ladite deuxième partie va analyser ces niveaux de grandeurs physiques vis-à-vis de niveaux de référence.

A cet égard, la deuxième partie comprend avantageusement l'exécution d'un logiciel implémentant au moins un arbre de décision.

Avantageusement, lesdites délivrances par le composant sans contact des signaux de test dans la première partie comporte des délivrances dans des modes différentiels et/ou à entrée/sortie unique (« single ended », selon une expression anglosaxonne bien connue de l'homme du métier).

Plus précisément, le composant sans contact comporte deux bornes de sortie et deux bornes d'entrée connectées au circuit d'adaptation d'impédance et destinées à la délivrance et à la réception de signaux de communication sans contact, par exemple des signaux radiofréquence.

La première partie comprend alors :
- une première délivrance sur les deux bornes de sortie de deux premiers signaux de test en opposition de phases et
- une réception de deux premiers signaux correspondants sur les deux bornes d'entrée.

On a donc ici une délivrance dans un mode différentiel.

Les résultats déterminés par ces délivrances comportent alors le niveau différentiel du courant circulant dans le circuit d'adaptation d'impédance ainsi que l'amplitude différentielle des deux premiers signaux correspondants reçus et/ou la phase de l'un des deux premiers signaux correspondants reçus.

D'une façon générale la phase d'un signal reçu est le déphasage de ce signal reçu par rapport au signal correspondant émis (ou la différence de phase entre ce signal reçu et le signal correspondant émis). Ce signal émis est par exemple cadencé par l'oscillateur local à la fréquence porteuse, par exemple 13,56 MHz.

Dans ce mode différentiel, puisque le déphasage entre les deux premiers signaux reçus est de 180°, il suffit de déterminer la phase de l'un seulement des deux premiers signaux reçus.

La première partie comporte également une deuxième délivrance sur une première borne de sortie d'un deuxième signal de test et une réception sur une première borne d'entrée d'un deuxième signal correspondant. On est donc ici dans un mode à entrée/sortie unique.

Le résultat déterminé par cette deuxième délivrance comporte alors l'amplitude et/ou la phase du deuxième signal correspondant reçu.

La première partie comprend également une troisième délivrance sur une deuxième borne de sortie d'un troisième signal de test et une réception sur une deuxième borne d'entrée d'un troisième signal correspondant.

On est donc là encore dans un mode à entrée/sortie unique mais cette fois-ci sur l'autre borne de sortie et l'autre borne d'entrée.

Le résultat déterminé par cette troisième délivrance comporte l'amplitude et/ou la phase du troisième signal correspondant reçu.

Bien que l'on ait affecté les termes « première », « deuxième », « troisième », au mot « délivrance », ceci ne préjuge pas de l'ordre dans lequel sont faites ces délivrances.

En fait, ceci n'a aucune importance et on peut effectuer par exemple les deux délivrances en mode à entrée/sortie unique avant la délivrance des signaux de test en mode différentiel ou l'inverse, ou encore placer la délivrance en mode différentiel entre les deux délivrances en mode à entrée/sortie unique.

En fait, cette première partie vise à obtenir les niveaux des différentes grandeurs physiques. Ces niveaux pourront être alors par exemple stockés et analysés ultérieurement dans la deuxième partie.

A cet égard, ledit au moins un arbre de décision utilisé dans la deuxième partie comporte par exemple trois niveaux de décision.

La deuxième partie comprend alors, selon un mode de mise en œuvre, une première étape comportant
- au premier niveau de décision, une première comparaison entre ledit niveau différentiel de courant et au moins un niveau différentiel de référence, puis,
- au deuxième niveau de décision, des deuxièmes comparaisons entre ladite amplitude différentielle et/ou la phase et des amplitudes différentielles de référence et/ou des phases de référence puis,
- au troisième niveau de décision, une détermination de la différence entre l'amplitude et/ou la phase du deuxième signal reçu correspondant et l'amplitude et/ou la phase du troisième signal reçu correspondant et des troisièmes comparaisons entre cette différence d'amplitude et/ou de phase et des différences d'amplitude et/ou de phase de référence.

En fonction des résultats de ces comparaisons, on va donc parcourir l'arbre de décisions pour arriver à un diagnostic conduisant à la détection et à l'identification de certains défauts ou alors à un diagnostic concluant à ce stade, à une absence de défaut.

Cela étant, certains types de défauts peuvent ne pas pouvoir être diagnostiqués au cours de cette première étape.

C'est le cas en particulier lorsque le composant sans contact comporte deux bornes de sortie supplémentaires connectées au circuit d'adaptation d'impédance et destinées à connecter le circuit d'adaptation d'impédance à une ou plusieurs résistances d'amortissement.

Dans ce cas, si la première étape de la deuxième partie de révèle aucun défaut détectable, la deuxième partie peut comporter une deuxième étape destinée à détecter d'éventuels défauts du type court-circuit au niveau de ces bornes de sortie supplémentaires.

Plus précisément, à cet égard, il est avantageusement prévu une réexécution de la première partie après avoir configuré les deux bornes de sortie supplémentaires en haute impédance et la deuxième étape comporte alors par exemple des comparaisons supplémentaires entre respectivement ledit niveau différentiel du courant, ladite amplitude différentielle et/ou la phase, ladite différence d'amplitude et/ou de phase et au moins un niveau différentiel de référence supplémentaire, au moins une amplitude différentielle de référence supplémentaires et/ou au moins une phase de référence supplémentaire, au moins une différence d'amplitude de référence supplémentaire et/ou au moins une différence de phase de référence supplémentaire.

Les différents niveaux de référence et/ou les différents niveaux de référence supplémentaires peuvent par exemple avoir été élaborés lors d'une partie préalable, par exemple par simulation et/ou création volontaire de défauts dans le circuit d'adaptation d'impédance par exemple.

Comme indiqué ci-avant, le composant sans contact peut être un microcontrôleur NFC.

Par ailleurs, comme indiqué ci-avant, le procédé peut être mis en œuvre avant insertion de la carte dans un appareil destiné à supporter une fonction de communication sans contact, par exemple un téléphone mobile cellulaire ou une tablette sans que ces exemples ne soient limitatifs.

En variante, le procédé peut être mis en œuvre au sein d'un appareil destiné à supporter une fonction de communication sans contact et équipé de ladite carte. Ceci peut être utile comme indiqué ci-avant pour une mise en œuvre de la détection éventuelle de défauts lors d'un retour client.

Selon un autre aspect, il est proposé un ensemble électronique, comprenant une carte, un système fixé sur ladite carte et comportant un circuit d'adaptation d'impédance couplé à un composant sans contact, et un dispositif de détection configuré pour effectuer une détection sur ladite carte de défauts éventuels dans le système fixé sur ladite carte, le dispositif de détection comportant des premiers moyens incorporés dans le composant sans contact lui-même et configurés pour effectuer une première partie de ladite détection.

Selon un mode de réalisation, les défauts éventuels appartiennent au groupe comportant des défauts éventuels dans les composants du circuit d'adaptation d'impédance, des défauts éventuels au niveau des connexions de ces composants sur ladite carte, des défauts éventuels au niveau des connexions du composant sans contact sur ladite carte.

Selon un mode de réalisation, le circuit d'adaptation d'impédance est destiné à être couplé à une antenne lors de ladite première partie.

Selon un mode de réalisation, ledit groupe comporte en outre des défauts éventuels au niveau des points de couplage avec ladite antenne.

Selon un mode de réalisation, un défaut éventuel comporte un défaut du type court-circuit ou du type circuit ouvert.

Ainsi, par exemple, pour un composant, un défaut de type court-circuit se traduit par une liaison électrique entre ses bornes. Pour une borne, un défaut de type court-circuit se traduit par exemple par une liaison de cette borne avec la masse du circuit.

Pour un composant un défaut de type circuit ouvert se traduit par exemple par une non fonctionnalité du composant et pour une borne un tel défaut se traduit par exemple par un non passage de signal à travers cette borne.

Selon un mode de réalisation, les premiers moyens sont configurés pour délivrer des résultats à l'issue de la première partie, et le dispositif de détection comprend en outre des moyens d'analyse configurés pour, lors d'une deuxième partie de ladite détection, analyser lesdits résultats de façon à diagnostiquer les éventuels défauts.

Selon un mode de réalisation, les moyens d'analyse sont incorporés au sein du composant sans contact, ou bien au sein d'une unité de traitement, fixée sur la carte mais distincte dudit composant sans contact, ou bien au sein d'une unité de traitement non supportée par ladite carte.

Selon un mode de réalisation, les premiers moyens comportent des moyens de délivrance configurés pour délivrer des signaux de tests dans le circuit d'adaptation d'impédance et les résultats comportent des niveaux de grandeurs physiques résultant de ces délivrances de signaux de tests, les premiers moyens comportant des moyens de détermination configurés pour déterminer lesdits niveaux.

Selon un mode de réalisation, les moyens d'analyse sont configurés pour analyser lesdits niveaux de grandeurs physiques vis-à-vis de niveaux de référence.

Selon un mode de réalisation, les moyens d'analyse sont configurés pour exécuter un logiciel implémentant au moins un arbre de décision.

Selon un mode de réalisation, les moyens de délivrance sont configurés pour délivrer les signaux de test dans des modes différentiels et/ou à entrée/sortie unique.

Selon un mode de réalisation, le composant sans contact comporte deux bornes de sortie et deux bornes d'entrée connectées au circuit d'adaptation d'impédance et destinées à la délivrance et à la réception de signaux de communication sans contact, et les moyens de délivrance sont configurés pour:
- effectuer une première délivrance sur les deux bornes de sortie de deux premiers signaux de test en opposition de phase et recevoir deux premiers signaux correspondants sur les deux bornes d'entrée, et les moyens de détermination sont configurés pour déterminer le niveau différentiel du courant circulant dans le circuit d'adaptation d'impédance ainsi que l'amplitude différentielle des deux premiers signaux correspondants reçus et/ou la phase de l'un de ces deux premiers signaux correspondants reçus,
- effectuer une deuxième délivrance sur une première borne de sortie d'un deuxième signal de test et recevoir sur une première borne d'entrée d'un deuxième signal correspondant, et les moyens de détermination sont configurés pour déterminer l'amplitude et/ou la phase du deuxième signal correspondant reçu,
- effectuer une troisième délivrance sur une deuxième borne de sortie d'un troisième signal de test et recevoir sur une deuxième borne d'entrée d'un troisième signal correspondant, et les moyens de détermination sont configurés pour déterminer l'amplitude et/ou la phase du troisième signal correspondant reçu.

Selon un mode de réalisation, ledit au moins un arbre comporte trois niveaux de décisions et les moyens d'analyse sont configurés pour effectuer une première étape comportant :
- au premier niveau de décision, une première comparaison entre ledit niveau différentiel du courant et au moins un niveau différentiel de référence, puis
- au deuxième niveau de décision, des deuxièmes comparaisons entre ladite amplitude différentielle et/ou la phase et des amplitudes différentielles de référence et/ou des phases de référence, puis
- au troisième niveau de décision, une détermination de la différence entre l'amplitude et/ou la phase dudit deuxième signal reçu correspondant et l'amplitude et/ou la phase dudit troisième signal reçu correspondant et des troisièmes comparaisons entre cette différence d'amplitude et/ou de phase et des différences d'amplitudes de référence et/ou des différence de phase de référence.

Selon un mode de réalisation, le composant sans contact comporte deux bornes de sortie supplémentaires connectées au circuit d'adaptation d'impédance et destinées à connecter le circuit d'adaptation d'impédance à une ou plusieurs résistances d'amortissement, et si la première étape de la deuxième partie ne révèle aucun défaut détectable, les moyens d'analyse sont configurés pour effectuer une deuxième étape destinée à détecter d'éventuels défauts du type court-circuit au niveau des bornes de sortie supplémentaires.

Selon un mode de réalisation, les deux bornes de sortie supplémentaires sont configurées en haute impédance, les premiers moyens sont configurés pour effectuer une réexécution de la première partie, et les moyens d'analyse sont configurés pour effectuer lors de la deuxième étape, des comparaisons supplémentaires entre respectivement ledit niveau différentiel du courant, ladite amplitude différentielle et/ou la phase, ladite différence d'amplitude et/ou de phase et au moins un niveau différentiel de référence supplémentaire, au moins une amplitude différentielle de référence supplémentaire et/ou au moins une phase de référence supplémentaire, au moins une différence d'amplitude et/ou de phase de référence supplémentaire.

Selon un mode de réalisation, l'ensemble électronique comprend des moyens de mémoire destinés à stocker les niveaux de référence et/ou les niveaux de référence supplémentaires.

Selon un mode de réalisation, le composant sans contact est un contrôleur NFC.

Selon un autre aspect, il est proposé un composant sans contact, appartenant à l'ensemble électronique tel que défini ci-avant.

Selon un mode de réalisation, ce composant sans contact comprend des premiers moyens configurés pour mettre en œuvre au moins la première partie du procédé de détection tel que défini ci-avant.

Selon un autre aspect, il est proposé un appareil, par exemple un téléphone mobile cellulaire ou une tablette, destiné à supporter une fonction de communication sans contact et incorporant un ensemble électronique tel que défini ci-avant.

D'autres avantages et caractéristiques de l'invention apparaîtront à l'examen de la description détaillée de modes de réalisation et de mise en œuvre, nullement limitatifs, et des dessins annexés sur lesquels :
[Fig 1] illustre un exemple de réalisation de l'invention ;
[Fig 2] illustre un exemple de réalisation de l'invention ;
[Fig 3] illustre un exemple de réalisation de l'invention ;
[Fig 4] illustre un exemple de mise en œuvre de l'invention ;
[Fig 5] illustre un exemple de mise en œuvre de l'invention ;
[Fig 6] illustre un exemple de mise en œuvre de l'invention
[Fig 7] illustre un exemple de mise en œuvre de l'invention ;
[Fig 8] illustre un exemple de mise en œuvre de l'invention ;
[Fig 9] illustre un exemple de mise en œuvre de l'invention.

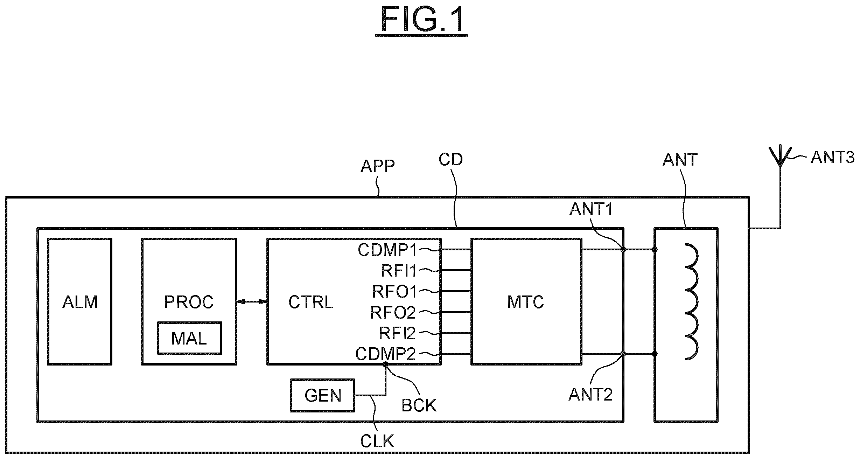

Sur la figure 1, la référence APP désigne un appareil de communication, par exemple un téléphone mobile cellulaire, en particulier du type « smartphone », ou une tablette, équipé d'une antenne ANT3 pour l'établissement des communications téléphoniques.

Dans le cas présent, l'appareil comporte également un système NFC comportant un composant sans contact CTLR, par exemple un microcontrôleur NFC, connecté à un circuit d'adaptation d'impédance MTC (« Matching Circuit »).

Ce système microcontrôleur CTLR-circuit d'adaptation d'impédance MTC est fixé de façon classique et connue en soi, par exemple par soudures de billes, sur une carte imprimée CD.

La carte CD supporte par ailleurs ici un microprocesseur PROC couplé au microcontrôleur CTLR.

La carte CD comporte également un module d'alimentation ALM destiné à alimenter la carte, ainsi qu'un générateur GEN apte à délivrer sur une borne ou broche BCK du microcontrôleur CTLR, un signal d'horloge CLK.

Outre cette broche BCK, le microcontrôleur CTLR comporte notamment six autres bornes ou broches CDMP1, RFI1, RFO1, RFO2, RFI2 et CDMP2 dont les fonctions seront détaillées plus en détails ci-après.

Ces broches sont reliées au circuit d'adaptation d'impédance MTC.

Par ailleurs, une antenne NFC, référencée ANT, est également couplée au circuit d'adaptation d'impédance MTC par l'intermédiaire de deux points de connexion ANT1, ANT2.

Dans l'exemple décrit ici, l'antenne ANT est l'antenne NFC effectivement présente dans l'appareil APP. Elle peut être connectée à la carte CD par l'intermédiaire de connexions spécifiques (par exemple des connexions connues par l'homme du métier sous la dénomination anglosaxonne de « Pogo pin »).

Pour réaliser la détection de défauts éventuels dans le système CTLR-MTC fixé sur la carte CD, il est possible, comme montré sur la figure 1, de coupler l'antenne ANT effectivement présente dans le téléphone sur la carte CD et de réaliser cette détection de défauts au sein du téléphone lui-même.

En variante, il est possible de détecter des défauts éventuels dans le système CTLR-MTC monté sur la carte CD avant d'insérer la carte CD dans l'appareil APP. Dans ce cas, on pourra alors avantageusement connecter sur les deux bornes ANT1, ANT2 un circuit émulant les caractéristiques de l'antenne future. Ce circuit émulant l'antenne peut être par exemple un circuit résistif inductif capacitif (RLC).

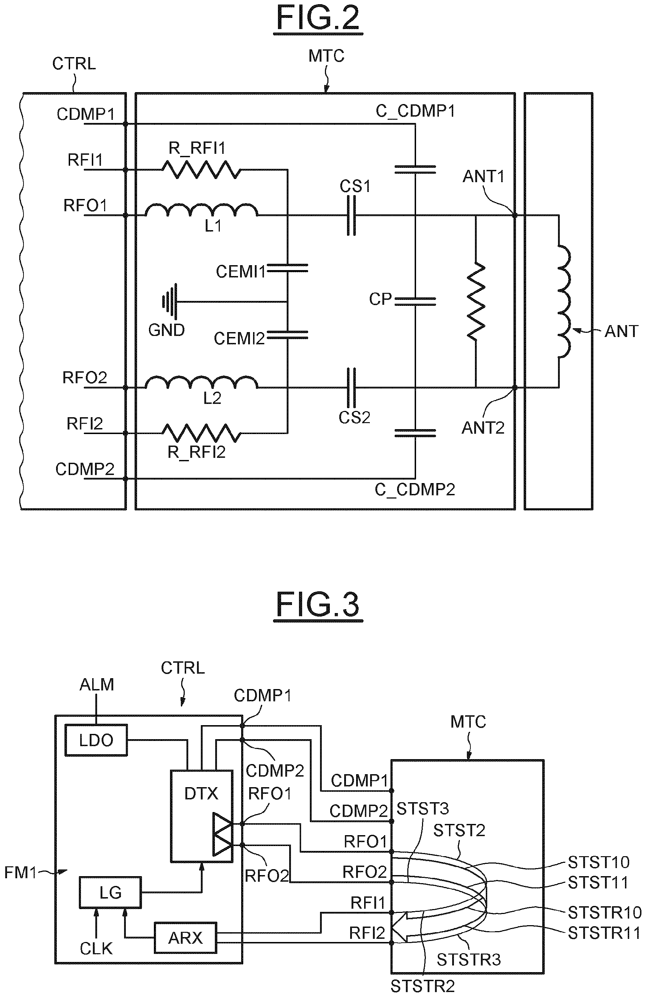

Comme illustré sur la figure 2, dans l'exemple décrit, le microcontrôleur CTLR possède deux bornes de sortie RFO1, RFO2 utilisables en mode lecteur ou pour la génération de la modulation de charge active ou passive en mode carte et deux autres bornes RFI1 et RFI2 utilisables en mode lecteur et en mode carte.

A cet égard, le microcontrôleur CTRL peut être équipé d'un commutateur interne permettant de court-circuiter les bornes RFO1 et RFO2 pour un fonctionnement en mode carte ou de ne pas court-circuiter ces bornes RFO1 et RFO2 pour autoriser un fonctionnement en mode lecteur ou lors de la génération de la modulation de charge active ou passive en mode carte.

Le circuit externe d'adaptation d'impédance MTC est connecté entre les deux points de couplage ANT1, ANT2 et les différentes bornes RFI1, RFO1, RFO2, RFI2 ainsi que les bornes supplémentaires CDMP1 et CDMP2.

La structure d'un tel circuit d'adaptation d'impédance MTC est classique et connue en soi.

Ce circuit d'adaptation d'impédance comporte ici un filtre destiné à filtrer les interférences électromagnétiques (filtre EMI).

Ce filtre est classiquement un filtre du type LC comportant ici une bobine L1 connectée en série entre la borne RFO1 et la masse GND avec un condensateur CEMI1.

Le filtre EMI comporte également une bobine L2 connectée en série entre la borne RFO2 et la masse avec un condensateur CEMI2.

Le circuit d'adaptation d'impédance MTC comporte par ailleurs deux condensateurs CS1, CS2 connectés en série entre respectivement les bobines L1 et L2 et les points de couplage ANT1 et ANT2.

Ces condensateurs sont choisis pour maximiser le courant dans l'antenne de façon à augmenter l'amplitude du champ électromagnétique.

Le circuit d'adaptation d'impédance MTC comporte également deux résistances R_RFI1 et R_RFI2 respectivement connectées entre les bornes RFI1 et RFI2 et les nœuds communs aux bobines L1 et L2 et aux condensateurs CS1 et CS2.

Deux autres condensateurs C_CDMP1 et C_CDMP2 sont respectivement connectés entre les bornes de sortie supplémentaires CDMP1 et CDMP2 et les points de couplage ANT1 et ANT2.

Un autre condensateur CP, de valeur capacitive moindre, est connecté en parallèle aux bornes de l'antenne ANT. De même, une résistance RP est connectée en parallèle entre les deux points de couplage ANT1 et ANT2.

Les bornes de sortie supplémentaires CDMP1 et CDMP2 permettent de relier le circuit d'adaptation d'impédance MTC à des résistances dites résistance d'amortissement, de façon à venir amortir dans le mode carte, le circuit résonnant que forme le composant CMP avec l'antenne ANT1 et le circuit externe d'adaptation d'impédance MTC.

Si l'on se réfère maintenant plus particulièrement à la figure 3, on voit que le microcontrôleur CTLR comporte des premiers moyens FM1 configurés pour effectuer une première partie de la détection de défauts éventuels.

Cette première partie comporte ici une obtention de niveaux de grandeurs physiques mesurés que l'on détaillera ci-après.

Ces premiers moyens FM1 comportent ici une logique de contrôle LG recevant le signal d'horloge CLK depuis la borne BCK (figure 1).

Cette logique de commande vise notamment à élaborer des signaux de test qui vont être délivrés sur les différentes bornes de sortie du microcontrôleur CTLR reliées au circuit d'adaptation d'impédance MTC par l'intermédiaire d'un circuit de pilotage d'émission (« driver ») DTX.

Ces signaux de test, que l'on détaillera plus en détails ci-après, vont donner lieu à la réception de signaux correspondants sur certaines des bornes du microcontrôleur CTLR et vont permettre la détermination de certains niveaux de grandeurs physiques par des moyens de réception ARX.

Ces moyens DTX et ARX sont de structure classique et connue en soi.

Par ailleurs, les premiers moyens FM1 comportent également ici un régulateur à faible chute de tension LDO (« Low Drop Out Voltage ») recevant une tension d'alimentation de la part des moyens d'alimentation ALM et délivrant une tension régulée VDDRF au circuit de pilotage DTX.

Comme illustré très schématiquement sur la figure 3, les délivrances de signaux de test par le composant sans contact CTLR comportent des délivrances dans des modes différentiels et/ou à entrée/sortie unique.

Plus précisément, dans un mode différentiel, deux signaux de tests en opposition de phase STST10 et STST11 sont respectivement délivrés sur les bornes de sortie RFO1 et RFO2 et il en résulte la réception sur les deux bornes d'entrée RFI1 et RFI2 de deux signaux correspondants reçus STSTR10 et STSTR11.

Dans une délivrance en mode entrée/sortie unique, on peut délivrer sur la borne de sortie RFO1 un signal de test STST2 et recevoir sur la borne d'entrée correspondante RFI1 un signal correspondant reçu STSTR2.

Dans une autre délivrance à entrée/sortie unique, on peut délivrer sur la borne de sortie RFO2 un signal de test STST3 et recevoir sur la borne d'entrée RFI2 le signal correspondant STSTR3.

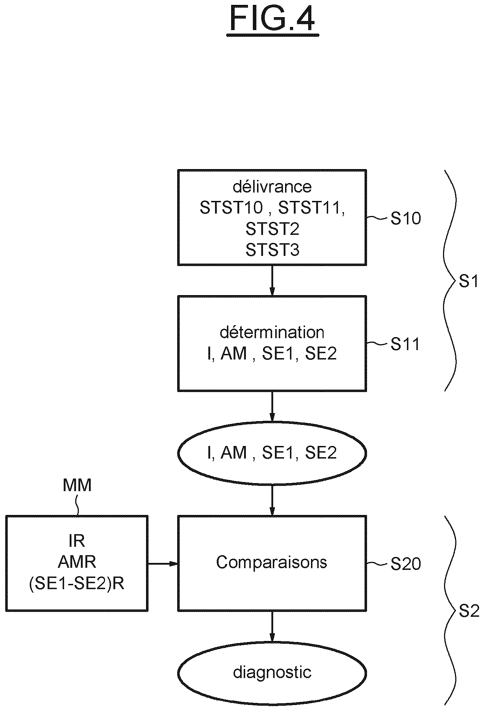

Comme illustré sur la figure 4, cette première partie S1 de la détection de défaut éventuel comporte donc
- la délivrance dans l'étape S10 des signaux de tests STST10, STST11, STST2 et STST3 puis,
- dans l'étape S11, la détermination à partir des signaux reçus correspondants
- du niveau différentiel I du courant circulant dans le circuit d'adaptation d'impédance,
- de l'amplitude différentielle AM des deux signaux différentiels reçus correspondant aux deux signaux de tests émis dans le mode différentiel, ainsi que
- des amplitudes SE1 et SE2 des signaux de tests reçus STSTR2 et STSTR3 correspondant respectivement aux deux signaux de tests STST2 et STST3 émis dans le mode à entrée/sortie unique.

Puis, dans une deuxième partie du procédé de détection, des moyens d'analyse MAL logés ici dans le microprocesseur PROC (figure 1) analysent les niveaux I, AM, SE1, SE2 des grandeurs physiques correspondantes vis-à-vis de niveaux de référence IR, AMR, (SE1-SE2)R en procédant notamment à des comparaisons S20, de façon à établir un diagnostic.

Ces niveaux de référence IR, AMR, (SE1-SE2)R sont stockés dans une mémoire MM.

A titre d'exemple non limitatif, les signaux de tests STST10, STST11, STST2 et STST3 sont des impulsions de l'ordre de 100 à 200 microsecondes d'un signal de porteuse, par exemple à 13,56 MHz, ayant une amplitude de 2,5 volts.

Le niveau différentiel I du courant circulant dans le circuit d'adaptation d'impédance peut par exemple être mesuré très simplement par la mesure du courant délivré par dans le régulateur LDO.

Quant aux amplitudes différentielles AM et aux amplitudes SE1 et SE2, elles sont déterminés dans le bloc de réception ARX de façon classique.

Cela étant, le bloc ARX permet également un calcul de phase.

Il serait donc possible d'utiliser des phases à la place des amplitudes différentielles AM et à la place des amplitudes SE1 et SE2.

A cet égard, que l'on soit dans un mode différentiel ou dans un mode à entrée/sortie unique, la phase d'un signal reçu est le déphasage ce signal reçu rapport au signal correspondant émis.

Il serait également possible d'utiliser à la fois des amplitudes différentielles AM et des phases et à la fois des amplitudes SE1 et SE2 et des phases.

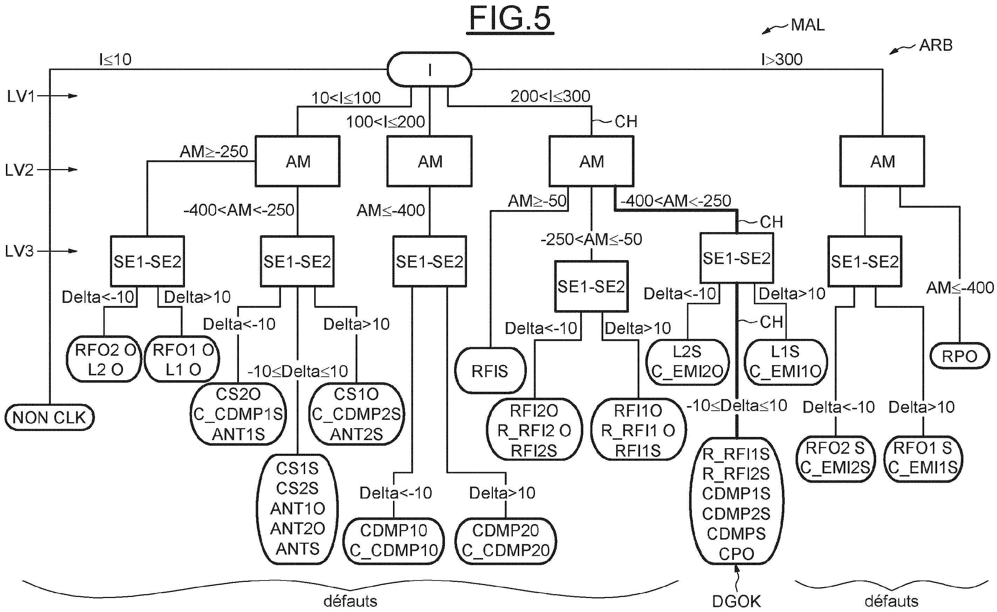

Comme illustré sur la figure 5, pour procéder à la deuxième partie de la détection, les moyens d'analyse, réalisés par exemple de façon logicielle au sein du microprocesseur, mettent en œuvre un arbre de décision ARB ayant plusieurs niveaux de décisions, ici trois niveaux de décisions LV1, LV2 et LV3.

A chaque niveau, les moyens d'analyse procèdent à des comparaisons des différents niveaux de grandeurs physiques obtenus dans la première partie de la détection, avec les niveaux de référence IR, AMR, et (SE1-SE2)R.

Plus précisément, au premier niveau LV1 de l'arbre ARB, on compare le niveau différentiel de courant à quatre niveaux différentiels de référence respectivement égaux à 10, 100, 200 et 300 milliampères.

Au niveau LV2 de l'arbre ARB, les moyens d'analyse MAL comparent l'amplitude différentielle AM à trois amplitudes différentielles de référence respectivement égales à -50, -250 et -400.

Il convient de noter ici que ces amplitudes de référence correspondent à des niveaux numériques en sortie de convertisseurs analogiques numériques utilisés pour la mesure de ces amplitudes et dont le niveau maximum correspond par exemple à -500.

La valeur médiane de l'échelle de sortie du convertisseur correspond par exemple à 2 volts.

Au niveau LV3 de l'arbre ARB, les moyens d'analyse élaborent tout d'abord la différence Delta=SE1-SE2 et compare cette différence Delta à deux amplitudes de référence respectivement égales à -10 et +10.

Là encore, ces amplitudes de référence correspondent à des différences de niveaux de sortie du convertisseur analogique numérique.

A l'issue de ce dernier niveau de comparaison, on obtient différents états de sortie qui correspondent soit à des défauts détectés soit dans le cas présent à un état DGOK considéré comme un état sans défaut détectable détecté en sortie de l'arbre ARB.

Plus précisément, la lettre « O » suivant la référence d'un composant ou d'une borne, correspond à un défaut au niveau de ce composant ou de cette borne, du type circuit ouvert.

La lettre « S » suivant la référence de ce composant ou de cette borne correspond à un défaut du type court-circuit au niveau de ce composant ou de cette borne. Pour un composant, un court-circuit relie ses 2 bornes entre elles. Pour une borne, un court-circuit la relie avec la masse du circuit.

Plus précisément, au niveau LV1, si le niveau différentiel I est inférieur ou égal à 10 milliampères, alors cela signifie qu'il y a une absence du signal CLK, c'est-à-dire probablement un défaut au niveau de la borne BCK du microcontrôleur CTLR destinée à recevoir ce signal d'horloge CLK.

Si le niveau différentiel I est supérieur à 10 milliampères, alors on procède au niveau LV2, à des comparaisons de l'amplitude différentielle AM avec des amplitudes différentielles de référence.

On procède ensuite, en fonction du résultat de ces comparaisons, à différentes comparaisons de la différence Delta avec les amplitudes de référence -10 et +10.

Ainsi, si le niveau différentiel I est supérieur à 10 et inférieur ou égal à 100, et que l'amplitude différentielle AM est supérieure ou égale à -250 et que la différence Δ est inférieure à -10, alors on en conclut qu'il y a un défaut de type circuit ouvert au niveau de la borne de sortie RFO2 et/ou de la bobine L2.

Si par contre, lors de la dernière comparaison, la différence Delta est supérieure à 10, alors on peut en conclure qu'il y a un défaut de type circuit ouvert au niveau de la borne de sortie RFO1 et/ou de la bobine L1.

Toujours dans l'hypothèse où le niveau différentiel I est supérieur à 10 et inférieur ou égal à 100, et dans l'hypothèse où l'amplitude différentielle AM est comprise entre -400 et -250, alors une différence Delta inférieure ou égale à 10 et supérieure ou égale à -10 caractérise un défaut du type court-circuit au niveau des condensateurs CS1 et/ou CS2 et/ou un défaut de type circuit ouvert au niveau des points de couplage ANT1 et/ou ANT2 et/ou un défaut de type court-circuit au niveau de l'antenne ANT elle-même.

A des fins de simplification de la description, on ne décrira pas plus en détails les autres chemins de l'arbre ARB aboutissant à la détection de défauts éventuels, la figure 5 étant explicite en elle-même à cet égard.

Par contre, on voit que l'arbre ARB comporte un chemin CH aboutissant à l'état DGOK.

Ce chemin CH est parcouru lorsque le niveau différentiel de courant I est supérieur à 200 et inférieur ou égal à 300 milliampères, lorsque l'amplitude différentielle AM est comprise entre -400 et -250 et lorsque la différence delta est inférieure ou égale à 10 et supérieure ou égale à -10.

L'état DGOK est représentatif d'une absence de défaut détecté dans la majorité des composants et des bornes du système microcontrôleur NFC-circuit d'adaptation d'impédance et est également représentatif de défauts potentiels mais non détectables du type court-circuit au niveau des résistances R_RFI1, R_RFI2, au niveau des bornes auxiliaires CDMP1 et CDMP2, entre ces deux bornes (un tel court-circuit entre les deux bornes CDMP1 et CDMP2 étant référencé CDMP S) ainsi qu'un défaut de type circuit ouvert au niveau du condensateur CP.

Bien qu'il soit possible de stopper l'analyse en sortie de l'arbre ARB, car la majorité des défauts potentiels ont été détectés, il est possible, si l'on souhaite, de poursuivre l'analyse une fois l'état DGOK atteint.

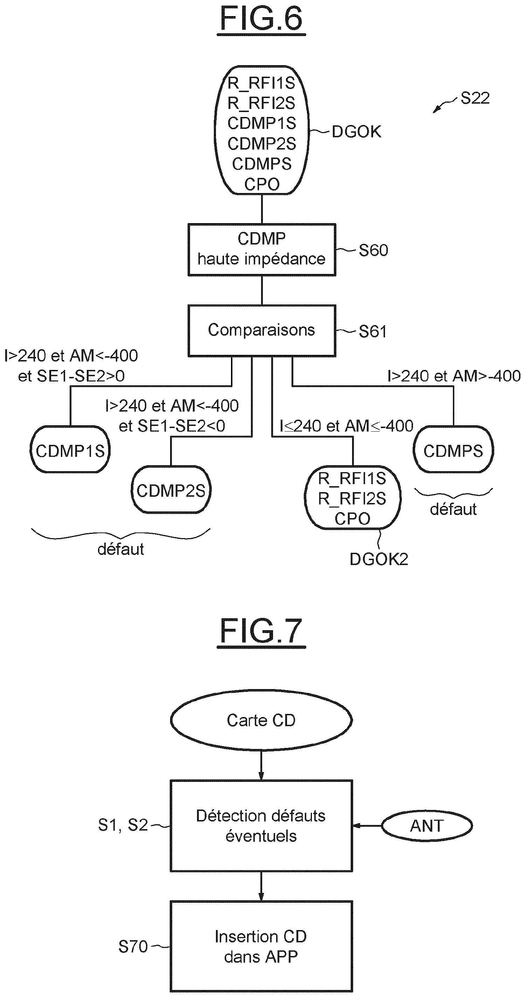

Dans ce cas, comme illustré sur la figure 6, l'analyse comporte une deuxième étape S22 dans laquelle on place les deux bornes CDMP en haute impédance (étape S60) et l'on ré-exécute la première partie de la détection c'est-à-dire que l'on délivre à nouveau les signaux de test qui ont été utilisés précédemment.

On mesure alors de nouveau les niveaux I, AM, SE1 et SE2.

Les moyens d'analyse procèdent alors dans l'étape S61 à une série de comparaisons comme illustré sur la figure 6. Ces comparaisons visent à comparer les niveaux mesurés I, AM, SE1 et SE2 à des niveaux de référence supplémentaires, également stockés dans la mémoire MM.

Plus précisément, si le niveau différentiel I est supérieur à 240 milliampères, et si l'amplitude différentielle AM est inférieure à -400 et si la différence SE1-SE2 est positive, alors ceci est représentatif d'un défaut de court-circuit au niveau de la borne supplémentaire CDMP1.

Si le niveau différentiel est supérieur à 240 milliampères, l'amplitude différentielle inférieure à -400 et la différence SE1-SE2 est négative alors on a un défaut de court-circuit au niveau de la borne CDMP2.

Si le niveau I est supérieur à 240 milliampères et l'amplitude différentielle supérieure à -400, alors on a un défaut de type court-circuit CDMP S entre les deux bornes supplémentaires CDMP1 et CDMP2.

Si par contre le niveau I est inférieur ou égal à 240 milliampères et l'amplitude différentielle AM est inférieure ou égale à -400, alors on se retrouve dans un état DGOK2 représentatif d'une absence de défaut détecté sachant qu'un défaut de type court-circuit au niveau des résistances R_RFI1 et R_RFI2 n'est pas détectable de même qu'un défaut de type circuit ouvert au niveau du condensateur CP.

Dans ce cas, et si le système est toujours en défaut, alors d'autres investigations avec d'autres moyens classiques peuvent être menées au niveau de ces résistances et de ce condensateur CP.

Comme indiqué ci-avant et comme illustré sur la figure 7, il est possible d'effectuer la détection des défauts éventuels (parties S1 et S2) en couplant la carte CD à une antenne émulant l'antenne future, avant d'insérer la carte CD dans l'appareil APP (étape S70).

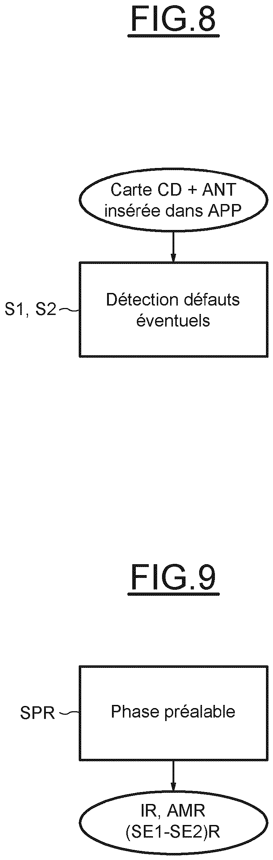

En variante, comme illustré sur la figure 8, il est possible d'effectuer la détection des défauts éventuels (parties S1 et S2) lorsque la carte CD est insérée dans l'appareil APP et couplée à l'antenne, par exemple lors d'un retour client suite à un défaut constaté.

Comme illustré schématiquement sur la figure 9, les différents niveaux de référence IR, AMR, (SE1-SE2)R et/ou les différents niveaux de référence supplémentaires peuvent par exemple avoir été élaborés lors d'une partie préalable SPR.

Cette partie préalable SPR utilise les mêmes valeurs de signaux de test que celles utilisées dans la première partie S1 de la détection. Elle peut comporter par exemple des simulations et/ou des créations volontaires de défauts dans le circuit d'adaptation d'impédance. Cette partie préalable peut aussi être effectuée sur plusieurs cartes équipées des circuits d'adaptation d'impédance de façon à prendre en compte d'éventuelles variations dans les procédés de fabrication, et effectuer ensuite des moyennes des différents niveaux de référence obtenus à partir de ces différentes cartes.

## Revendications

1. Procédé de détection sur carte de défauts éventuels dans un système fixé sur ladite carte, le système comportant un circuit d'adaptation d'impédance (MTC) couplé à un composant sans contact (CTLR) comportant deux bornes de sortie (RFO1, RFO2) et deux bornes d'entrée (RFI1, RFI2) connectées au circuit d'adaptation d'impédance et destinées à la délivrance et à la réception de signaux de communication sans contact, ladite détection comportant une première partie (S1) effectuée par le composant sans contact lui-même et une deuxième partie (S2) comprenant l'exécution d'un logiciel implémentant au moins un arbre de décision (ARB) et analysant des résultats (I, AM, SE1, SE2) issus de la première partie de façon à diagnostiquer les éventuels défauts,
- la première partie (S1) comportant des délivrances par le composant sans contact (CTLR) de signaux de tests dans le circuit d'adaptation d'impédance (MTC) et les résultats comportant des niveaux de grandeurs physiques résultant de ces délivrances de signaux de tests, lesdits niveaux étant déterminés par le composant sans contact,
- lesdites délivrances par le composant sans contact (CTLR) des signaux de tests comportant des délivrances dans des modes différentiels et/ou à entrée/sortie unique,
- la première partie comprenant:
- une première délivrance sur les deux bornes de sortie (RFO1, RFO2) de deux premiers signaux de test en opposition de phase et une réception de deux premiers signaux correspondants sur les deux bornes d'entrée (RFI1, RFI2), et les résultats déterminés par ces délivrances comportent le niveau différentiel (I) du courant circulant dans le circuit d'adaptation d'impédance ainsi que l'amplitude différentielle (AM) des deux premiers signaux correspondants reçus et/ou une phase de l'un des deux premiers signaux correspondants reçus,
- une deuxième délivrance sur une première borne de sortie (RFO1) d'un deuxième signal de test et une réception sur une première borne d'entrée (RFI1) d'un deuxième signal correspondant, le résultat déterminé par cette deuxième délivrance comportant l'amplitude (SE1) et/ou la phase du deuxième signal correspondant reçu,
- une troisième délivrance sur une deuxième borne de sortie (RFO2) d'un troisième signal de test et une réception sur une deuxième borne d'entrée (RFI2) d'un troisième signal correspondant, le résultat déterminé par cette troisième délivrance comportant l'amplitude (SE2) et/ou la phase du troisième signal correspondant reçu.

2. Procédé selon la revendication 1, dans lequel les défauts éventuels appartiennent au groupe comportant des défauts éventuels dans les composants du circuit d'adaptation d'impédance (MTC), des défauts éventuels au niveau des connexions de ces composants sur ladite carte, des défauts éventuels au niveau des connexions du composant sans contact (CTLR) sur ladite carte.

3. Procédé selon la revendication 1 ou 2, dans lequel lors de la première partie on couple le circuit d'adaptation d'impédance à une antenne (ANT).

4. Procédé selon les revendications 2 et 3, dans lequel ledit groupe comporte en outre des défauts éventuels au niveau des points de couplage (ANT1, ANT2) avec ladite antenne.

5. Procédé selon la revendication 2 ou 4, dans lequel un défaut éventuel comporte un défaut du type court-circuit (S) ou du type circuit ouvert (O).

6. Procédé selon l'une des revendications précédentes, dans lequel la deuxième partie (S2) est effectuée au sein du composant sans contact, ou bien au sein d'une unité de traitement, fixée sur la carte mais distincte dudit composant sans contact, ou bien au sein d'une unité de traitement non supportée par ladite carte.

7. Procédé selon la revendication 6, dans lequel ladite deuxième partie (S2) analyse lesdits niveaux de grandeurs physiques vis-à-vis de niveaux de référence.

8. Procédé selon l'une des revendications précédentes, dans lequel ledit au moins un arbre comporte trois niveaux de décisions (LV1, LV2, LV3) et la deuxième phase (S2) comprend une première étape comportant :
- au premier niveau de décision (LV1), une première comparaison entre ledit niveau différentiel du courant et au moins un niveau de référence, puis
- au deuxième niveau de décision (LV2), des deuxièmes comparaisons entre ladite amplitude différentielle et/ou la phase et des amplitudes différentielles de référence et/ou des phases de référence, puis
- au troisième niveau de décision (LV3), une détermination de la différence entre l'amplitude et/ou la phase dudit deuxième signal reçu correspondant et l'amplitude et/ou la phase dudit troisième signal reçu correspondant et des troisièmes comparaisons entre cette différence d'amplitude et/ou de phase et des différences d'amplitudes et/ou de phases de référence.

9. Procédé selon la revendication 8, dans lequel le composant sans contact comporte deux bornes de sortie supplémentaires (CDMP1, CDMP2) connectées au circuit d'adaptation d'impédance et destinées à connecter le circuit d'adaptation d'impédance à une ou plusieurs résistances d'amortissement, et si la première étape de la deuxième partie (S2) ne révèle aucun défaut détectable, la deuxième partie comporte une deuxième étape destinée à détecter d'éventuels défauts du type court-circuit au niveau des bornes de sortie supplémentaires (CDMP1, CDMP2).

10. Procédé selon la revendication 9, comprenant une réexécution de la première partie (S1) après avoir configuré les deux bornes de sortie supplémentaires (CDMP1, CDMP2) en haute impédance, et la deuxième étape comportent des comparaisons supplémentaires entre respectivement ledit niveau différentiel du courant, ladite amplitude différentielle et/ou ladite phase, ladite différence d'amplitude et/ou de phase et au moins un niveau de référence supplémentaire, au moins une amplitude différentielle de référence supplémentaire et/ou au moins une phase de référence supplémentaire, au moins une différence d'amplitude et/ou de phase de référence supplémentaire.

11. Procédé selon la revendication 10 prise en combinaison avec la revendication 7 ou l'une des revendications 1 à 9 prise en combinaison avec la revendication 7, comprenant une partie préalable d'élaboration des niveaux de référence et/ou des niveaux de référence supplémentaires.

12. Procédé selon l'une des revendications précédentes, dans lequel le composant sans contact est un contrôleur (CTLR) compatible avec la technologie de communication en champ proche.

13. Procédé selon l'une des revendications précédentes, mis en œuvre avant insertion de la carte dans un appareil destiné à supporter une fonction de communication sans contact.

14. Procédé selon l'une des revendications précédentes, mis en œuvre au sein d'un appareil destiné à supporter une fonction de communication sans contact et équipé de ladite carte.

15. Ensemble électronique, comprenant une carte (CD), un système fixé sur ladite carte et comportant un circuit d'adaptation d'impédance (MTC) couplé à un composant sans contact (CTLR) comportant deux bornes de sortie et deux bornes d'entrée connectées au circuit d'adaptation d'impédance et destinées à la délivrance et à la réception de signaux de communication sans contact, et un dispositif de détection configuré pour effectuer une détection sur ladite carte de défauts éventuels dans le système fixé sur ladite carte, le dispositif de détection comportant des premiers moyens (FM1) incorporés dans le composant sans contact lui-même (CTLR) et configurés pour effectuer une première partie de ladite détection, les premiers moyens (FM1) étant configurés pour délivrer des résultats à l'issue de la première partie, et le dispositif de détection comprend en outre des moyens d'analyse (MAL) configurés pour, lors d'une deuxième partie de ladite détection, exécuter un logiciel implémentant au moins un arbre de décision et analyser lesdits résultats de façon à diagnostiquer les éventuels défauts,
- les premiers moyens (FM1) comportent des moyens de délivrance configurés pour délivrer des signaux de tests dans le circuit d'adaptation d'impédance et les résultats comportent des niveaux de grandeurs physiques résultant de ces délivrances de signaux de tests, les premiers moyens comportent des moyens de détermination configurés pour déterminer lesdits niveaux,
- les moyens de délivrance (DTX) sont configurés pour délivrer les signaux de test dans des modes différentiels et/ou à entrée/sortie unique,
- les moyens de délivrance sont configurés pour:
-- effectuer une première délivrance sur les deux bornes de sortie de deux premiers signaux de test en opposition de phase et recevoir deux premiers signaux correspondants sur les deux bornes d'entrée, et les moyens de détermination sont configurés pour déterminer le niveau différentiel du courant circulant dans le circuit d'adaptation d'impédance ainsi que l'amplitude différentielle des deux premiers signaux correspondants reçus et/ou une phase de l'un des deux premiers signaux correspondants reçus,
-- effectuer une deuxième délivrance sur une première borne de sortie d'un deuxième signal de test et recevoir sur une première borne d'entrée d'un deuxième signal correspondant, et les moyens de détermination sont configurés pour déterminer l'amplitude et/ou la phase du deuxième signal correspondant reçu,
-- effectuer une troisième délivrance sur une deuxième borne de sortie d'un troisième signal de test et recevoir sur une deuxième borne d'entrée d'un troisième signal correspondant, et les moyens de détermination sont configurés pour déterminer l'amplitude et/ou la phase du troisième signal correspondant reçu.

16. Ensemble électronique selon la revendication 15, dans lequel les défauts éventuels appartiennent au groupe comportant des défauts éventuels dans les composants du circuit d'adaptation d'impédance (MTC), des défauts éventuels au niveau des connexions de ces composants sur ladite carte, des défauts éventuels au niveau des connexions du composant sans contact (CTLR) sur ladite carte.

17. Ensemble électronique selon la revendication 15 ou 16, dans lequel le circuit d'adaptation d'impédance (MTC) est destiné à être couplé à une antenne (ANT) lors de ladite première partie.

18. Ensemble électronique selon les revendications 16 et 17, dans lequel ledit groupe comporte en outre des défauts éventuels au niveau des points de couplage (ANT1, ANT2) avec ladite antenne.

19. Ensemble électronique selon la revendication 16 ou 18, dans lequel un défaut éventuel comporte un défaut du type court-circuit (S) ou du type circuit ouvert (O).

20. Ensemble électronique selon l'une des revendication 15 à 19, dans lequel les moyens d'analyse (MAL) sont incorporés au sein du composant sans contact, ou bien au sein d'une unité de traitement, fixée sur la carte mais distincte dudit composant sans contact, ou bien au sein d'une unité de traitement non supportée par ladite carte.

21. Ensemble électronique selon l'une des revendications 15 à 20, dans lequel les moyens d'analyse (MAL) sont configurés pour analyser lesdits niveaux de grandeurs physiques vis-à-vis de niveaux de référence.

22. Ensemble électronique selon l'une des revendications 15 à 21, dans lequel ledit au moins un arbre comporte trois niveaux de décisions (LV1, LV2, LV3) et les moyens d'analyse (MAL) sont configurés pour effectuer une première étape comportant :
- au premier niveau de décision, une première comparaison entre ledit niveau différentiel du courant et au moins un niveau différentiel de référence, puis
- au deuxième niveau de décision, des deuxièmes comparaisons entre ladite amplitude différentielle et/ou la phase et des amplitudes différentielles de référence et/ou des phases de référence, puis
- au troisième niveau de décision, une détermination de la différence entre l'amplitude et/ou la phase dudit deuxième signal reçu correspondant et l'amplitude et/ou la phase dudit troisième signal reçu correspondant et des troisièmes comparaisons entre cette différence d'amplitude et/ou de phase et des différences d'amplitudes et/ou de phases de référence.

23. Ensemble électronique selon la revendication 22, dans lequel le composant sans contact (CTLR) comporte deux bornes de sortie supplémentaires connectées au circuit d'adaptation d'impédance et destinées à connecter le circuit d'adaptation d'impédance à une ou plusieurs résistances d'amortissement, et si la première étape de la deuxième partie ne révèle aucun défaut détectable, les moyens d'analyse (MAL) sont configurés pour effectuer une deuxième étape destinée à détecter d'éventuels défauts du type court-circuit au niveau des bornes de sortie supplémentaires.

24. Ensemble électronique selon la revendication 23, dans lequel les deux bornes de sortie supplémentaires sont configurées en haute impédance, les premiers moyens (FM1) sont configurés pour effectuer une réexécution de la première partie, et les moyens d'analyse (MAL) sont configurés pour effectuer lors de la deuxième étape, des comparaisons supplémentaires entre respectivement ledit niveau différentiel du courant, ladite amplitude différentielle et/ou ladite phase, ladite différence d'amplitude et/ou de phase et au moins un niveau de référence supplémentaire, au moins une amplitude différentielle de référence supplémentaire et/ou au moins une phase de référence supplémentaire, au moins une différence d'amplitude et/ou de phase de référence supplémentaire.

25. Ensemble électronique selon la revendication 24 prise en combinaison avec la revendication 19 ou l'une des revendications 15 à 23 prise en combinaison avec la revendication 19, comprenant des moyens de mémoire destinés à stocker les niveaux de référence et/ou les niveaux de référence supplémentaires.

26. Ensemble électronique selon l'une des revendications 15 à 25, dans lequel le composant sans contact est un microcontrôleur (CTLR) compatible avec une technologie de communication en champ proche.

27. Composant sans contact appartenant à l'ensemble électronique selon l'une des revendications 15 à 26.

28. Composant sans contact comprenant des premiers moyens (FM1) configurés pour mettre en œuvre au moins la première partie du procédé de détection selon l'une des revendications 1 à 14.

29. Appareil destiné à supporter une fonction de communication sans contact et incorporant un ensemble électronique selon l'une des revendications 15 à 28.

30. Appareil selon la revendication 29, étant un téléphone mobile cellulaire ou une tablette.

## Patentansprüche

1. Verfahren zum Erkennen eventueller Fehler auf einer Leiterplatte in einem auf der Leiterplatte angebrachten System, wobei das System eine Impedanzanpassungsschaltung (MTC) umfasst, die mit einer kontaktlosen Komponente (CTLR) gekoppelt ist, die zwei Ausgangsklemmen (RFO1, RFO2) und zwei Eingangsklemmen (RFI1, RFI2) umfasst, die mit der Impedanzanpassungsschaltung verbunden und zum Ausgeben und zum Empfangen von kontaktlosen Kommunikationssignalen bestimmt sind, wobei das Erkennen einen ersten Teil (S1), der durch die kontaktlose Komponente selbst erfolgt, und einen zweiten Teil (S2) umfasst, der das Ausführen einer Software enthält, die mindestens einen Entscheidungsbaum (ARB) implementiert und die Ergebnisse (I, AM, SE1, SE2) aus dem ersten Teil analysiert, um eventuelle Fehler zu diagnostizieren,
- wobei der erste Teil (S1) Ausgaben von Testsignalen durch die kontaktlose Komponente (CTLR) in der Impedanzanpassungsschaltung (MTC) umfasst und die Ergebnisse Pegel physikalischer Größen umfassen, die sich aus diesen Ausgaben von Testsignalen ergeben, wobei die Pegel von der kontaktlosen Komponente bestimmt werden,
- wobei die Ausgaben von Testsignalen durch die kontaktlose Komponente (CTLR) die Ausgaben in differenziellen Modi und/oder mit einem einzigen Eingang/Ausgang umfassen,
- wobei der erste Teil Folgendes enthält:
- eine erste Ausgabe an den beiden Ausgangsklemmen (RFO1, RFO2) von zwei ersten gegenphasigen Testsignalen und einen Empfang von zwei ersten entsprechenden Signalen an den beiden Eingangsklemmen (RFI1, RFI2), und wobei die durch diese Ausgaben bestimmten Ergebnisse den Differenzpegel (I) des in der Impedanzanpassungsschaltung fließenden Stroms sowie die Differenzamplitude (AM) der beiden ersten entsprechenden empfangenen Signale und/oder einer Phase eines der beiden ersten entsprechenden empfangenen Signale umfassen,
- eine zweite Ausgabe an einer ersten Ausgangsklemme (RFO1) eines zweiten Testsignals und einen Empfang an einer ersten Eingangsklemme (RFI1) eines zweiten entsprechenden Signals, wobei das durch die zweite Ausgabe bestimmte Ergebnis die Amplitude (SE1) und/oder die Phase des empfangenen zweiten entsprechenden Signals umfasst,
- eine dritte Ausgabe an einer zweiten Ausgangsklemme (RFO2) eines dritten Testsignals und einen Empfang an einer zweiten Eingangsklemme (RFI2) eines dritten entsprechenden Signals, wobei das durch die dritte Ausgabe bestimmte Ergebnis die Amplitude (SE2) und/oder die Phase des empfangenen dritten entsprechenden Signals umfasst.

2. Verfahren nach Anspruch 1, wobei die eventuellen Fehler zur Gruppe gehören, die eventuelle Fehler in den Komponenten der Impedanzanpassungsschaltung (MTC), eventuelle Fehler an den Anschlüssen dieser Komponenten auf der Leiterplatte, eventuelle Fehler an den Anschlüssen der kontaktlosen Komponente (CTLR) auf der Leiterplatte umfasst.

3. Verfahren nach Anspruch 1 oder 2, wobei im ersten Teil die Impedanzanpassungsschaltung mit einer Antenne (ANT) gekoppelt wird.

4. Verfahren nach den Ansprüchen 2 und 3, wobei die Gruppe ferner eventuelle Fehler an den Koppelpunkten (ANT1, ANT2) mit der Antenne umfasst.

5. Verfahren nach Anspruch 2 oder 4, wobei ein eventueller Fehler einen Fehler vom Typ Kurzschluss (S) oder vom Typ offener Stromkreis (O) umfasst.

6. Verfahren nach einem der vorhergehenden Ansprüche, wobei der zweite Teil (S2) entweder innerhalb der kontaktlosen Komponente oder innerhalb einer Verarbeitungseinheit, die auf der Leiterplatte angebracht, aber von der kontaktlosen Komponente getrennt ist, oder innerhalb einer Verarbeitungseinheit, die von der Leiterplatte nicht unterstützt wird, durchgeführt wird.

7. Verfahren nach Anspruch 6, wobei der zweite Teil (S2) die Pegel physikalischer Größen in Bezug auf Referenzpegel analysiert.

8. Verfahren nach einem der vorhergehenden Ansprüche, wobei der mindestens eine Baum drei Entscheidungsebenen (LV1, LV2, LV3) umfasst und die zweite Phase (S2) einen ersten Schritt umfasst, der Folgendes umfasst:
- auf der ersten Entscheidungsebene (LV1), einen ersten Vergleich zwischen dem Differenzpegel des Stroms und mindestens einem Referenzpegel, dann
- auf der zweiten Entscheidungsebene (LV2), zweite Vergleiche zwischen der Differenzamplitude und/oder der Phase und Referenz-Differenzamplituden und/oder Referenzphasen, dann
- auf der dritten Entscheidungsebene (LV3), eine Bestimmung des Unterschieds zwischen der Amplitude und/oder der Phase des entsprechenden zweiten empfangenen Signals und der Amplitude und/oder der Phase des entsprechenden dritten empfangenen Signals und dritte Vergleiche zwischen der Amplituden- und/oder Phasendifferenz und Referenzamplituden- und/oder -Phasendifferenzen.

9. Verfahren nach Anspruch 8, wobei die kontaktlose Komponente zwei zusätzliche Ausgangsklemmen (CDMP1, CDMP2) umfasst, die mit der Impedanzanpassungsschaltung verbunden und dazu bestimmt sind, die Impedanzanpassungsschaltung mit einem oder mehreren Dämpfungswiderständen zu verbinden, und, wenn der erste Schritt des zweiten Teils (S2) keinen erkennbaren Fehler zeigt, der zweite Teil einen zweiten Schritt umfasst, der dazu bestimmt ist, eventuelle Fehler vom Typ Kurzschluss an den zusätzlichen Ausgangsklemmen (CDMP1, CDMP2) zu erkennen.

10. Verfahren nach Anspruch 9, das eine erneute Ausführung des ersten Teils (S1) nach dem Konfigurieren der beiden zusätzlichen Ausgangsklemmen (CDMP1, CDMP2) mit hoher Impedanz umfasst, und wobei der zweite Schritt zusätzliche Vergleiche zwischen jeweils dem Differenzpegel des Stroms, der Differenzamplitude und/oder der Phase, der Amplituden- und/oder Phasendifferenz und mindestens einem zusätzlichen Referenzpegel, mindestens einer zusätzlichen Referenz-Differenzamplitude und/oder mindestens einer zusätzlichen Referenzphase, mindestens einer zusätzlichen Referenz-Amplitude und/oder -Phasendifferenz.

11. Verfahren nach Anspruch 10 in Kombination mit Anspruch 7 oder einem der Ansprüche 1 bis 9 in Kombination mit Anspruch 7, umfassend einen vorhergehenden Teil des Erstellens der Referenzpegel und/oder der zusätzlichen Referenzpegel.

12. Verfahren nach einem der vorhergehenden Ansprüche, wobei die kontaktlose Komponente eine Steuerung (CTLR) ist, die mit der Nahfeldkommunikationstechnologie kompatibel ist.

13. Verfahren nach einem der vorhergehenden Ansprüche, das vor dem Einsetzen der Leiterplatte in ein Gerät durchgeführt wird, das dazu bestimmt ist, eine kontaktlose Kommunikationsfunktion zu unterstützen.

14. Verfahren nach einem der vorhergehenden Ansprüche, das in einem Gerät durchgeführt wird, das dazu bestimmt ist, eine kontaktlose Kommunikationsfunktion zu unterstützen, und das mit der Leiterplatte ausgestattet ist.

15. Elektronische Baugruppe, die eine Leiterplatte (CD), ein auf der Leiterplatte angebrachtes System und eine Impedanzanpassungsschaltung (MTC), die mit einer kontaktlosen Komponente (CTLR) gekoppelt ist, die zwei Ausgangsklemmen und zwei Eingangsklemmen umfasst, die mit der Impedanzanpassungsschaltung verbunden und zum Ausgeben und zum Empfangen von kontaktlosen Kommunikationssignalen bestimmt sind, und eine Erkennungsvorrichtung umfasst, die so konfiguriert ist, dass sie auf der Leiterplatte eine Erkennung möglicher Fehler im auf der Leiterplatte angebrachten System durchführt, wobei die Erkennungsvorrichtung erste Mittel (FM1) umfasst, die in die kontaktlose Komponente selbst (CTLR) integriert und so konfiguriert sind, dass sie einen ersten Teil der Erkennung durchführt, wobei die ersten Mittel (FM1) so konfiguriert sind, dass sie nach Abschluss des ersten Teils Ergebnisse liefern, und die Erkennungsvorrichtung ferner Analysemittel (MAL) umfasst, die so konfiguriert sind, dass sie bei einem zweiten Teil der Erkennung eine Software ausführen, die mindestens einen Entscheidungsbaum implementiert, und die Ergebnisse analysieren, um eventuelle Fehler zu diagnostizieren,
- wobei die ersten Mittel (FM1) Bereitstellungsmittel umfassen, die so konfiguriert sind, dass sie Testsignale in der Impedanzanpassungsschaltung ausgeben, und die Ergebnisse Pegel physikalischer Größen umfassen, die sich aus dem Ausgeben von Testsignalen ergeben, wobei die ersten Mittel Bestimmungsmittel umfassen, die so konfiguriert sind, dass sie die Pegel bestimmen,
- wobei die Ausgabemittel (DTX) so konfiguriert sind, dass sie die Testsignale in einem differenziellen und/oder einem Einzeleingang-/-ausgangsmodus ausgeben,
- wobei die Ausgabemittel für Folgendes konfiguriert sind:
-- Durchführen einer ersten Ausgabe von zwei ersten gegenphasigen Testsignalen an den beiden Ausgangsklemmen und Empfangen von zwei ersten entsprechenden Signalen an den beiden Eingangsklemmen, und wobei die Bestimmungsmittel so konfiguriert sind, dass sie den Differenzpegel des in der Impedanzanpassungsschaltung fließenden Stroms sowie die Differenzamplitude der empfangenen beiden ersten entsprechenden Signale und/oder eine Phase eines der empfangenen beiden ersten entsprechenden Signale bestimmen,
-- Durchführen einer zweiten Ausgabe eines zweiten Testsignals an einer ersten Ausgangsklemme und Empfangen eines zweiten entsprechenden Signals an einer ersten Eingangsklemme, und wobei die Bestimmungsmittel so konfiguriert sind, dass sie die Amplitude und/oder die Phase des empfangenen zweiten entsprechenden Signals bestimmen,
-- Durchführen einer dritten Ausgabe eines dritten Testsignals an einer zweiten Ausgangsklemme und Empfangen eines dritten entsprechenden Signals an einer zweiten Eingangsklemme, und wobei die Bestimmungsmittel so konfiguriert sind, dass sie die Amplitude und/oder die Phase des empfangenen dritten entsprechenden Signals bestimmen.

16. Elektronische Baugruppe nach Anspruch 15, wobei die eventuellen Fehler zur Gruppe gehören, die eventuelle Fehler in den Komponenten der Impedanzanpassungsschaltung (MTC), eventuelle Fehler an den Anschlüssen der Komponenten auf der Leiterplatte, eventuelle Fehler an den Anschlüssen der kontaktlosen Komponente (CTLR) auf der Leiterplatte umfasst.

17. Elektronische Baugruppe nach Anspruch 15 oder 16, wobei die Impedanzanpassungsschaltung (MTC) dazu bestimmt ist, bei dem ersten Teil mit einer Antenne (ANT) gekoppelt zu werden.

18. Elektronische Baugruppe nach den Ansprüchen 16 und 17, wobei die Gruppe ferner eventuelle Fehler an den Koppelpunkten (ANT1, ANT2) mit der Antenne umfasst.

19. Elektronische Baugruppe nach Anspruch 16 oder 18, wobei ein eventueller Fehler einen Fehler vom Typ Kurzschluss (S) oder vom Typ offener Stromkreis (O) umfasst.

20. Elektronische Baugruppe nach einem der Ansprüche 15 bis 19, wobei die Analysemittel (MAL) entweder innerhalb der kontaktlosen Komponente oder innerhalb einer Verarbeitungseinheit, die auf der Leiterplatte angebracht, aber von der kontaktlosen Komponente getrennt ist, oder innerhalb einer Verarbeitungseinheit, die von der Leiterplatte nicht unterstützt wird, eingebaut sind.

21. Elektronische Baugruppe nach einem der Ansprüche 15 bis 20, wobei die Analysemittel (MAL) so konfiguriert sind, dass sie die Pegel physikalischer Größen in Bezug auf Referenzpegel analysieren.

22. Elektronische Baugruppe nach einem der Ansprüche 15 bis 21, wobei der mindestens eine Baum drei Entscheidungsebenen (LV1, LV2, LV3) umfasst und die Analysemittel (MAL) so konfiguriert sind, dass sie einen ersten Schritt ausführen, der Folgendes umfasst:
- auf der ersten Entscheidungsebene, einen ersten Vergleich zwischen dem Differenzpegel des Stroms und mindestens einem Referenz-Differenzpegel, dann
- auf der zweiten Entscheidungsebene, zweite Vergleiche zwischen der Differenzamplitude und/oder der Phase und den Referenz-Differenzamplituden und/oder den Referenzphasen, dann
- auf der dritten Entscheidungsebene, eine Bestimmung des Unterschieds zwischen der Amplitude und/oder der Phase des empfangenen zweiten entsprechenden Signals und der Amplitude und/oder der Phase des empfangenen dritten entsprechenden Signals und dritte Vergleiche zwischen der Amplituden- und/oder Phasendifferenz und Referenzamplituden- und/oder -phasendifferenzen.

23. Elektronische Baugruppe nach Anspruch 22, wobei die kontaktlose Komponente (CTLR) zwei zusätzliche Ausgangsklemmen umfasst, die mit der Impedanzanpassungsschaltung verbunden und dazu bestimmt sind, die Impedanzanpassungsschaltung mit einem oder mehreren Dämpfungswiderständen zu verbinden, und, wenn der erste Schritt des zweiten Teils keinen nachweisbaren Fehler zeigt, die Analysemittel (MAL) so konfiguriert sind, dass sie einen zweiten Schritt ausführen, der dazu bestimmt ist, mögliche Kurzschlussfehler an den zusätzlichen Ausgangsklemmen zu erkennen.

24. Elektronische Baugruppe nach Anspruch 23, wobei die beiden zusätzlichen Ausgangsklemmen hochohmig konfiguriert sind, die ersten Mittel (FM1) so konfiguriert sind, dass sie eine erneute Ausführung des ersten Teils durchführen, und die Analysemittel (MAL) so konfiguriert sind, dass sie im zweiten Schritt zusätzliche Vergleiche zwischen jeweils dem Differenzpegel des Stroms, der Differenzamplitude und/oder der Phase, der Amplituden- und/oder Phasendifferenz und mindestens einem zusätzlichen Referenzpegel, mindestens einer zusätzlichen Referenz-Differenzamplitude und/oder mindestens einer zusätzlichen Referenzphase, mindestens einer zusätzlichen Referenz-Amplitude- und/oder -Phasendifferenz durchführen.

25. Elektronische Baugruppe nach Anspruch 24 in Kombination mit Anspruch 19 oder einem der Ansprüche 15 bis 23 in Kombination mit Anspruch 19, die Speichermittel umfasst, die dazu bestimmt sind, die Referenzpegel und/oder die zusätzlichen Referenzpegel zu speichern.

26. Elektronische Baugruppe nach einem der Ansprüche 15 bis 25, wobei die kontaktlose Komponente ein Mikrosteuerung (CTLR) ist, die mit einer Nahfeldkommunikationstechnologie kompatibel ist.

27. Kontaktlose Komponente, die zur elektronischen Baugruppe nach einem der Ansprüche 15 bis 26 gehört.

28. Kontaktlose Komponente, die erste Mittel (FM1) umfasst, die so konfiguriert sind, dass sie mindestens den ersten Teil des Erkennungsverfahrens nach einem der Ansprüche 1 bis 14 durchführen.

29. Gerät, das dazu bestimmt ist, eine kontaktlose Kommunikationsfunktion zu unterstützen, und in dem eine elektronische Baugruppe nach einem der Ansprüche 15 bis 28 eingebaut ist.

30. Gerät nach Anspruch 29, wobei es sich um ein Mobiltelefon oder ein Tablet handelt.

## Claims

1. Method for detecting possible faults on a board in a system secured to said board, the system including an impedance matching circuit (MTC) coupled to a contactless component (CTLR) including two output terminals (RFO1, RFO2) and two input terminals (RFI1, RFI2) connected to the impedance matching circuit and intended for delivering and receiving contactless communication signals, said detection including a first part (S1) performed by the contactless component itself and a second part (S2) comprising the execution of software implementing at least one decision tree (ARB) and analysing results (I, AM, SE1, SE2) derived from the first part so as to diagnose any faults,
- the first part (S1) including deliveries by the contactless component (CTLR) of test signals in the impedance matching circuit (MTC) and the results including levels of physical quantities resulting from these deliveries of test signals, said levels being determined by the contactless component,
- said deliveries by the contactless component (CTLR) of the test signals including deliveries in differential and/or single input/output modes,
- the first part comprising:
- a first delivery on the two output terminals (RFO1, RFO2) of two first test signals in phase opposition and a reception of two first corresponding signals on the two input terminals (RFI1, RFI2), and the results determined by these deliveries include the differential level (I) of the current flowing in the impedance matching circuit as well as the differential amplitude (AM) of the two first corresponding signals received and/or a phase of one of the two first corresponding signals received,
- a second delivery on a first output terminal (RFO1) of a second test signal and a reception on a first input terminal (RFI1) of a second corresponding signal, the result determined by this second delivery comprising the amplitude (SE1) and/or the phase of the second corresponding signal received,
- a third delivery on a second output terminal (RFO2) of a third test signal and a reception on a second input terminal (RFI2) of a third corresponding signal, the result determined by this third delivery comprising the amplitude (SE2) and/or the phase of the third corresponding signal received.

2. Method according to claim 1, wherein the possible faults belong to the group including possible faults in the components of the impedance matching circuit (MTC), possible faults at the connections of these components on said board, and possible faults at the connections of the contactless component (CTLR) on said board.

3. Method according to claim 1 or 2, wherein during the first part the impedance matching circuit is coupled to an antenna (ANT).

4. Method according to claims 2 and 3, wherein said group furthermore includes possible defects at the points (ANT1, ANT2) of coupling with said antenna.

5. Method according to claim 2 or 4, wherein a possible defect includes a defect of the short-circuit type (S) or of the open circuit type (O).

6. Method according to one of the preceding claims, wherein the second part (S2) is carried out within the contactless component, or within a processing unit, secured on the card but separate from said contactless component, or within a processing unit not supported by said card.

7. Method according to claim 6, wherein said second part (S2) analyses said levels of physical quantities with respect to reference levels.

8. Method according to one of the preceding claims, wherein said at least one tree includes three decision levels (LV1, LV2, LV3) and the second phase (S2) comprises a first step including:
- at the first decision level (LV1), a first comparison between said differential current level and at least one reference level, then
- at the second decision level (LV2), second comparisons between said differential amplitude and/or the phase and the reference differential amplitudes and/or the reference phases, then
- at the third decision level (LV3), determining the difference between the amplitude and/or phase of said corresponding second received signal and the amplitude and/or phase of said corresponding third received signal and third comparisons between this amplitude and/or phase difference and the differences in reference amplitudes and/or phases.

9. Method according to claim 8, wherein the contactless component includes two additional output terminals (CDMP1, CDMP2) connected to the impedance matching circuit and intended to connect the impedance matching circuit to one or more damping resistors, and if the first step of the second part (S2) reveals no detectable defect, the second part includes a second step for detecting possible short-circuit type faults at the additional output terminals (CDMP1, CDMP2).

10. Method according to claim 9, comprising a re-execution of the first part (S1) after configuring the two additional output terminals (CDMP1, CDMP2) in high impedance, and the second step includes additional comparisons between respectively said differential level of the current, said differential amplitude and/or said phase, said difference in amplitude and/or phase and at least one additional reference level, at least one additional reference differential amplitude and/or at least one additional reference phase, at least one additional reference difference in amplitude and/or phase.

11. Method according to claim 10 taken in combination with claim 7 or one of claims 1 to 9 taken in combination with claim 7, comprising a prior part of developing the reference levels and/or additional reference levels.

12. Method according to one of the preceding claims, wherein the contactless component is a controller (CTLR) compatible with near-field communication technology.

13. Method according to one of the preceding claims, implemented before inserting the card into an apparatus intended to support a contactless communication function.

14. Method according to one of the preceding claims, implemented within an apparatus intended to support a contactless communication function and equipped with said card.

15. Electronic assembly, comprising a board (CD), a system attached to said board and including an impedance matching circuit (MTC) coupled to a contactless component (CTLR) including two output terminals and two input terminals connected to the impedance matching circuit and intended for delivering and receiving contactless communication signals, and a detection device configured to perform a detection on said card of possible faults in the system fixed on said card, the detection device including first means (FM1) incorporated in the contactless component itself (CTLR) and configured to perform a first part of said detection, the first means (FM1) being configured to deliver results at the end of the first part, and the detection device furthermore comprises analysis means (MAL) configured to, during a second part of said detection, execute software implementing at least one decision tree and analyse said results so as to diagnose any defects,
- the first means (FM1) include delivery means configured to deliver test signals in the impedance matching circuit and the results include levels of physical quantities resulting from these delivery of test signals, the first means include determination means configured to determine said levels,
- the delivery means (DTX) are configured to deliver the test signals in differential and/or single input/output modes,
- the delivery means are configured to:
-- performing a first delivery on the two output terminals of two first opposed-phase test signals and receiving the two first corresponding signals on the two input terminals, and the determination means are configured to determine the differential level of the current flowing in the impedance matching circuit as well as the differential amplitude of the first two corresponding signals received and/or a phase of one of the first two corresponding signals received,
-- performing a second delivery on a first output terminal of a second test signal and receiving on a first input terminal a second corresponding signal, and the determination means are configured to determine the amplitude and/or phase of the second corresponding signal received,
-- performing a third delivery on a second output terminal of a third test signal and receiving on a second input terminal a corresponding third signal, and the determination means are configured to determine the amplitude and/or phase of the corresponding third signal received.

16. Electronic assembly according to claim 15, wherein the possible faults belong to the group including possible faults in the components of the impedance matching circuit (MTC), possible faults at the connections of these components on said board, and possible faults at the connections of the contactless component (CTLR) on said board.

17. Electronic assembly according to claim 15 or 16, wherein the impedance matching circuit (MTC) is intended to be coupled to an antenna (ANT) during said first part.

18. Electronic assembly according to claims 16 and 17, wherein said group further includes possible defects at the coupling points (ANT1, ANT2) with said antenna.

19. Electronic assembly according to claim 16 or 18, wherein a possible fault includes a fault of the short-circuit type (S) or of the open circuit type (O).

20. Electronic assembly according to any one of claims 15 to 19, wherein the analysis means (MAL) are incorporated within the contactless component, or within a processing unit, fixed on the card but distinct from said contactless component, or within a processing unit not supported by said card.

21. Electronic assembly according to one of claims 15 to 20, wherein the analysis means (MAL) are configured to analyse said levels of physical quantities with respect to reference levels.

22. Electronic assembly according to one of claims 15 to 21, wherein said at least one tree includes three decision levels (LV1, LV2, LV3) and the analysis means (MAL) are configured to perform a first step comprising:
- at the first decision level, a first comparison between said differential current level and at least one reference differential level, then
- at the second decision level, second comparisons between said differential amplitude and/or the phase and reference differential amplitudes and/or reference phases, then
- at the third decision level, determining the difference between the amplitude and/or phase of said corresponding second received signal and the amplitude and/or phase of said corresponding third received signal and third comparisons between this amplitude and/or phase difference and the differences in reference amplitudes and/or phases.

23. Electronic assembly according to claim 22, wherein the contactless component (CTLR) includes two additional output terminals connected to the impedance matching circuit and intended to connect the impedance matching circuit to one or more damping resistors, and if the first step of the second part reveals no detectable defect, the analysis means (MAL) are configured to perform a second step to detect possible short-circuit type faults at the additional output terminals.

24. Electronic assembly according to claim 23, wherein the two additional output terminals are configured in high impedance, the first means (FM1) are configured to perform a re-execution of the first part, and the analysis means (MAL) are configured to perform, in the second step, additional comparisons between respectively said differential current level, said differential amplitude and/or said phase, said amplitude and/or phase difference and at least one additional reference level, at least one additional reference differential amplitude and/or at least one additional reference phase, at least one additional reference amplitude and/or phase difference.

25. Electronic assembly according to claim 24 taken in combination with claim 19 or one of claims 15 to 23 taken in combination with claim 19, comprising memory means for storing the reference levels and/or additional reference levels.

26. Electronic assembly according to any one of claims 15 to 25, wherein the contactless component is a microcontroller (CTLR) compatible with near-field communication technology.

27. Contactless component belonging to the electronic assembly according to one of claims 15 to 26.

28. Contactless component comprising first means (FM1) configured to implement at least the first part of the detection method according to one of claims 1 to 14.

29. Apparatus intended to support a contactless communication function and incorporating an electronic assembly according to any one of claims 15 to 28.

30. Apparatus according to claim 29, being a cellular mobile phone or a tablet.
